Europäisches Patentamt

European Patent Office

Office européen des brevets

(11) Veröffentlichungsnummer: **0 134 911**
A2

(12) **EUROPÄISCHE PATENTANMELDUNG**

(21) Anmeldenummer: 84106297.9

(22) Anmeldetag: 01.06.84

(51) Int. Cl.⁴: **H 05 K 13/02**

(30) Priorität: 26.07.83 DE 8321507 U
15.09.83 DE 3333374
11.10.83 DE 3336986

(43) Veröffentlichungstag der Anmeldung:
27.03.85 Patentblatt 85/13

(84) Benannte Vertragsstaaten:
AT BE CH DE FR GB IT LI LU NL SE

(71) Anmelder: Lemmer, Alfred
Machtlfingerstrasse 24
D-8000 München 70(DE)

(72) Erfinder: Lemmer, Alfred
Machtlfingerstrasse 24
D-8000 München 70(DE)

(74) Vertreter: Schmidt-Evers, Jürgen, Dipl.-Ing. et al,
Patentanwälte Dipl.-Ing. H. Mitscherlich Dipl.-Ing. K.
Gunschmann Dipl.-Ing. Dr.rer.nat. W. Körber Dipl.-Ing. J.
Schmidt-Evers Dipl.-Ing. W. Melzer Steinsdorfstrasse 10
D-8000 München 22(DE)

(54) IC-Stangenmagazin.

(57) Die Erfindung bezieht sich auf ein IC-Stangenmagazin, insbesondere solches, dessen Magazinkammer-Profil infolge einer nach innnen gerichteten Wandvorwölbung etwa U-Form hat. Es ist der Zweck der Erfindung, das IC-Stangenmagazin so auszugestalten, daß eine vereinfachte Handhabung bei der Entnahme eines oder mehrerer IC's möglich ist.

Dies wird dadurch erreicht, daß es ein am Ende des IC-Stangenmagazins angeordnetes auslenkbares Federelement aufweist, welches die Magazinkammer-Öffnung im unausgelenkten Zustand zumindest soweit verschließt, daß die in der Magazinkammer befindlichen IC's am Austritt gehindert werden, und welches den Austritt der IC's im entgegen der Federkraft ausgelenkten Zustand zuläßt. Das Federelement kann als separates Abschlußstück mit einem form- oder kraftschlüssig am Stangenmagazin festlegbaren Schaftteil versehen oder auch einstückig am Stangenmagazin angeformt sein. Das Abschlußstück bzw. das IC-Stangenmagazin kann mit einem IC-Vereinzelungssteckteil kombiniert werden, das auf den Endabschnitt des Stangenmagazins aufschiebbar ist und über das Ende des Stangenmagazins hinausragt. Das Vereinzelungsstück weist eine seitliche Entnahmeöffnung auf, deren Länge gleich oder etwas größer als die der im Stangenmagazin befindlichen IC's ist. Ferner ist das Vereinzelungssteckteil mit einem von Hand betätigbaren Auslenkelement für das Federelement versehen. Das Abschlußstück kann außerdem mit einer Verbindungsmuffe kombiniert werden, die das Verbinden von zwei Stangenmagazinen oder eines Stangenmagazins mit einem Anschlußstück für eine IC-Verwertungsvorrichtung ermöglicht und ein Auslenken des Federelementes durch einen entsprechenden Anschlag beim Zusammenstecken zuläßt.

FIG. 1

Croydon Printing Company Ltd

Alfred Lemmer
Machtlfinger Straße 24
8ooo München 7o

## IC-Stangenmagazin

Die Erfindung betrifft ein IC-Stangenmagazin, insbesondere ein solches, dessen Magazinkammer-Profil infolge einer nach innen gerichteten Wandvorwölbung etwa U-Form hat.

Integrierte Schaltungen, oder kurz IC's genannt, werden in der Regel in Stangenmagazinen gelagert und transportiert. Die Stangenmagazine sind beispielsweise etwa 5o cm lange Rohre aus durchsichtigem antistatischen Kunststoff mit einem etwa U-förmigen Kammerprofil. Die IC-Körper liegen in Reihe zwischen der Wandvorwölbung und der dieser gegenüberliegenden Wand des Stangenmagazins; die Anschlußbeine der IC's ragen in die die Schenkel des U-Kammerprofiles bildenden Kammerbereiche. Für verschiedene IC-Typen gibt es Stangenmagazine mit entsprechendem unterschiedlichen Profilquerschnitt.

Bisher werden die Stangenmagazine entweder mit Gummipfropfen oder mit sich quer durch die Magazinkammer erstreckenden Verschlußstiften verschlossen.Wenn aus dem Stangenmagazin ein IC oder mehrere IC's entnommen werden sollen, so muß der Gummipfropfen bzw. der Verschlußstift an einem Ende des Stangenmagazins entfernt und das Stangenmagazin dann gekippt werden, so daß die gewünschte Anzahl von IC's herausrutscht. Dann wird das offene Ende des Stangenmagazins mit einem Finger zugehalten und der Gummipfropfen bzw. der Verschlußstift wieder eingeführt. Dieses Verfahren ist dann besonders umständlich und schwierig, wenn das Stangenmagazin beispielsweise auf eine IC-Verwertungsvorrichtung aufgesetzt werden soll,

beispielsweise an einem Bestückungstisch für Leiterplatten. Das Stangenmagazin muß dann mit dem Finger
bis unmittelbar vor die Einsecköffnung an der IC-Verwertungsvorrichtung verschlossen gehalten werden. Kurz
vor dem Einstecken muß aber der verschließende Finger
dann aus Platzmangel doch von der Öffnung genommen werden,
wodurch die Gefahr besteht, daß ungewollt IC's vorher
aus dem Stangenmagazin herausgleiten.

Der Erfindung liegt die Aufgabe zugrunde, ein IC-Stangenmagazin der eingangs beschriebenen Art zu schaffen, welches
eine vereinfachte Handhabung bei der Entnahme eines oder
mehrerer IC's ermöglicht.

Diese Aufgabe wird durch die Merkmale des Anspruchs 1
gelöst.

Die erfindungsgemäße Ausgestaltung ermöglicht in einerseits einfacher und andererseits zuverlässiger sowie
handhabungsfreundlicher Weise den Abschluß des IC-Stangenmagazins, der lediglich durch ein Auslenken des Federelements aufzuheben ist, so daß eine beliebige Anzahl
IC's leicht entnommen werden können, und der nach dem
Freigeben des Federelements automatisch herbeigeführt
wird, so daß ein Herausfallen von IC's verhindert ist.

Das Federelement kann auch beim Einstecken beispielsweise
in eine IC-Verwertungsvorrichtung durch mechanische
Auslenkelemente aus seiner Schließstellung ausgelenkt
werden. Entscheidend ist, daß das Federelement dann, wenn
auf  dieses keine Auslenkkraft mehr ausgeübt wird, selbsttätig in die Schließstellung zurückgeht. Auf diese
Weise wird ein ungewolltes Herausgleiten von IC's aus
dem Stangenmagazin mit Sicherheit vermieden.

Eine Ausgestaltungsform der Erfindung bezieht sich auf
eine bevorzugt einstückige Anformung des Federelements

3

0134911

an das IC-Magazin. Hierdurch kann bei Vermeidung eines zusätzlichen Bauteils die Herstellung vereinfacht werden.

Eine vorteilhafte Weiterbildung der Erfindung kann darin bestehen, daß das Federelement einen in Bezug auf die Längsrichtung des Stangenmagazins schrägen Bereich aufweist, der das Auslenken des Federelements bewirkt, wenn er in Längsrichtung des Stangenmagazins gegen einen Auslenkanschlag gedrückt wird oder wenn der Auslenkanschlag gegen den schrägen Bereich gedrückt wird. Hier macht man sich also die beim Einschieben eines Stangenmagazins in eine IC-Verwertungsvorrichtung ohnehin erfolgende Längsverschiebung in Verbindung mit einer schrägen Ebene oder Keilfläche zunutze.

Der schräge Bereich sollte vorzugsweise die gedachte in Längsrichtung des Stangenmagazins verlaufende Verlängerung der höchsten Stelle der Wandvorwölbung schneiden. Dies deshalb, weil in der Regel das Anschlußstück in der IC-Verwertungsvorrichtung oder ein weiteres Stangenmagazin, mit dem das erstgenannte Stangenmagazin verbunden werden soll, den gleichen Profilquerschnitt wie das erstgenannte Stangenmagazin haben, wobei die höchste Stelle der Wandvorwölbung des Anschlußstückes oder des weiteren Stangenmagazins als Auslenkanschlag für das Federelement wirken.

Gemäß einer Weiterbildung ist das Federelement ein separates, zusätzliches Bauteil mit einem Schaftteil, der formschlüssig oder kraftschlüssig am Stangenmagazin festlegbar und deshalb leicht zu montieren bzw. zu entfernen ist.

Eine zweckmäßige Ausgestaltung der Erfindung kann ferner darin bestehen, daß das Federelement als Federzunge ausgebildet ist, die sich in Längsrichtung des Stangenmagazins durch die von der Wandvorwölbung gebildete Rinne gegen

das Ende des Stangenmagazins hin erstreckt und dort eine gegen die Magazinkammer-Öffnung hingerichtete Abbiegung aufweist. Durch diese Maßnahme wird gewährleistet, daß der Federweg der Federzunge im wesentlichen innerhalb der erwähnten Rinne liegt und eine äußerliche Veränderung des Anschlußstückes beim Auslenken der Federzunge praktisch nicht erfolgt.

Der schräge Bereich wird bei Ausbildung des Abschlußstückes als Hülse mit Federzunge vorzugsweise an das Ende der Abbiegung der Federzunge gelegt.

Eine vorteilhafte Möglichkeit zur Festlegung des Federelements besteht darin, das Schaftteil hülsenförmig auszubilden und auf das Stangenmagazin aufzuschieben.

Die Hülse kann so gestaltet sein, daß sie die von der Wandvorwölbung gebildete Rinne überbrückt, wobei dann die Federzunge, von der Hülse ausgehend, in Bezug auf die Längsrichtung des Stangenmagazins durch die Rinne zumindest teilweise schräg zum Ende des Stangenmagazins hin verläuft und dort im unausgelenkten Zustand am Boden der Rinne anliegt.

Die Hülse und/oder das Federelement können insbesondere einstückig ausgebildet und vorzugsweise aus Metall hergestellt sein. Alternativ dazu ist es möglich, die Hülse aus Kunststoff zu spritzen und das Federelement aus Metall herzustellen und an der Hülse zu befestigen. Eine Weiterbildung der letztgenannten Alternative kann darin bestehen, daß die aus Kunststoff gespritzte Hülse einen sich in Längsrichtung des Stangenmagazins erstreckenden Einsteckkanal für die Federzunge aufweist. Der Einsteckkanal kann mit einer gegen den Innenraum der Hülse hin offenen Ausnehmung versehen sein, wobei der in den Einsteckkanal einführbare Teil der Federzunge mit einer wellenartigen Ausbiegung versehen ist, die beim Einschieben der Federzunge in den Einsteckkanal in die Ausnehmung einrastet.

Die Ausbildung des Federelementes, bestehend aus Hülse und Federzunge hat noch den weiteren Vorteil, daß sie die Arretierung der Federzunge in der Öffnungsstellung zuläßt, wenn die Hülse mit der Federzunge von der Öffnung aus zurückgeschoben wird. Dies kann beispielsweise dann erfolgen, wenn das Stangenmagazin zumindest für eine bestimmte Zeit permanent offengehalten werden soll.

Ein vorteilhafter Festlegungsort für das Federelement ist der von der U-förmigen Wandvorwölbung gebildete Freiraum, der eine vollständige Aufnahme wenigstens des Schaftteils ermöglicht. Es ist möglich, das Federelement darin einzukleben. Dabei kann das Federelement aus einem Kunststoffstück mit einem dickeren Trägerkörper und einem einstückig mit diesem verbundenen dünneren Zungenelement bestehen. Zur einfacheren Durchführung der Klebeverbindung kann der Trägerkörper auf seiner betreffenden Seite mit einer Klebeschicht versehen sein.

Eine vorteilhafte Befestigungsmöglichkeit für das Federelement besteht darin, es mit seitlichen Ansätzen am Schaftteil bzw. an der Federzunge in Aussparungen aufzunehmen, die in den einander gegenüberliegenden Seitenwänden der Wandvorwölbung angeordnet sind. Eine solche Befestigung läßt sich leicht montieren bzw. demontieren, weil die stegförmigen Abschnitte des Stangenmagazins zum Ein- bzw. Ausführen der Ansätze in bzw. aus den Aussparungen verhältnismäßig leicht auseinandergebogen werden können, wonach sie elastisch wieder in ihre Ausgangsposition zurückkehren und das Federelement festlegen. Wenn die Aussparungen sich in die Wände fortsetzen, die an die Wandvorwölbung in Umfangsrichtung anschließen, können die Aussparungen bequem von oben eingearbeitet, z.B. gefräst, werden.

Eine andere Weiterbildung des IC-Stangenmagazins, der selbständige erfinderische Bedeutung beigemessen wird, kann darin bestehen, daß zum IC-Stangenmagazin zusätzlich ein IC-Vereinzelungssteckteil gehört, das -vom Ende des Stangenmagazins aus gesehen- vor dem Schaftteil bzw. die Hülse auf den Endabschnitt des Stangenmagazins aufschiebbar ist und über das Ende des Stangenmagazins hinausragt, daß das Vereinzelungssteckteil eine in Bezug auf die Längsrichtung des Stangenmagazins seitliche Entnahmeöffnung aufweist, deren in Längsrichtung des Stangenmagazins gemessene Länge gleich oder etwas größer ist als die Länge der im Stangenmagazin befindlichen IC's, daß das Vereinzelungssteckteil am Ende der Entnahmeöffnung einen Anschlag für die IC's aufweist, und daß an dem Vereinzelungssteckteil ein von Hand betätigbares Auslenkelement für das Federelement vorgesehen ist. Zur praktischen Ausgestaltung dieses Vereinzelungssteckteiles wird vorgeschlagen, daß es etwa die gleiche Querschnittsform wie und lediglich geringfügige größere Abmessungen als das Stangenmagazin hat, derart, daß es dessen Endabschnitt mit Preßsitz umgreifen kann, daß der über das Ende des Stangenmagazins überstehende Abschnitt des Vereinzelungssteckteils eine die Entnahmeöffnung bildende Wandaussparung aufweist, die sich etwa oberhalb der höchsten Stelle der nach innen gerichteten Wandvorwölbung befindet, daß sich am Ende des Vereinzelungssteckteils eine den Anschlag für die IC's bildende Abschlußwand befindet und daß in der Wandvorwölbung des Vereinzelungssteckteils ein Durchgreifloch für das Federelement vorgesehen ist.

Das Auslenkelement kann beispielsweise von einem Drahtbügel gebildet sein, der sich drehbar quer durch das Vereinzelungssteckteil erstreckt und in der von der Wandvorwölbung gebildeten Rinne eine Ausbiegung aufweist, die sich zwischen den schrägen Bereich des Federelements und den Boden der Rinne erstreckt.

Das Vereinzelungssteckteil kann aus Blech oder Kunststoff hergestellt sein. Es kann insbesondere mit der das Federelement tragenden Hülse einstückig ausgebildet sein oder aber ein von der erwähnten Hülse separates Teil sein.

Eine andere Weiterbildung des Abschlußstückes, der ebenfalls selbständige erfinderische Bedeutung beigemessen wird, kann darin bestehen, daß zu dem Abschlußstück eine Verbindungsmuffe zum Verbinden des Endabschnittes des Stangenmagazins mit einem Endabschnitt eines zweiten Stangenmagazins oder zum Aufstecken des Stangenmagazins auf ein Übernahme-Anschlußstück gehört, das den gleichen Querschnitt wie das Stangenmagazin hat, wobei die höchste Stelle der Wandvorwölbung am Ende des zweiten Stangenmagazins bzw. am Ende des Übernahme-Endstückes den Auslenkanschlag für das Federelement bildet. Die Verbindungsmuffe kann aus Kunststoff oder Blech hergestellt sein. Insbesondere ist es möglich, daß die Verbindungsmuffe und die das Federelement tragende Hülse einstückig ausgebildet sind. Sie können aber auch separate Teile sein.

Ausführungsbeispiele der Erfindung werden nachfolgend anhand der Zeichnungen beschrieben.

Es zeigt

Fig. 1 eine perspektivische Darstellung eines Endabschnittes eines IC-Stangenmagazins mit Abschlußstück, bestehend aus Hülse und federnder Zunge;

8                                   0134911

Fig. 2   einen Längsschnitt durch den Endabschnitt in

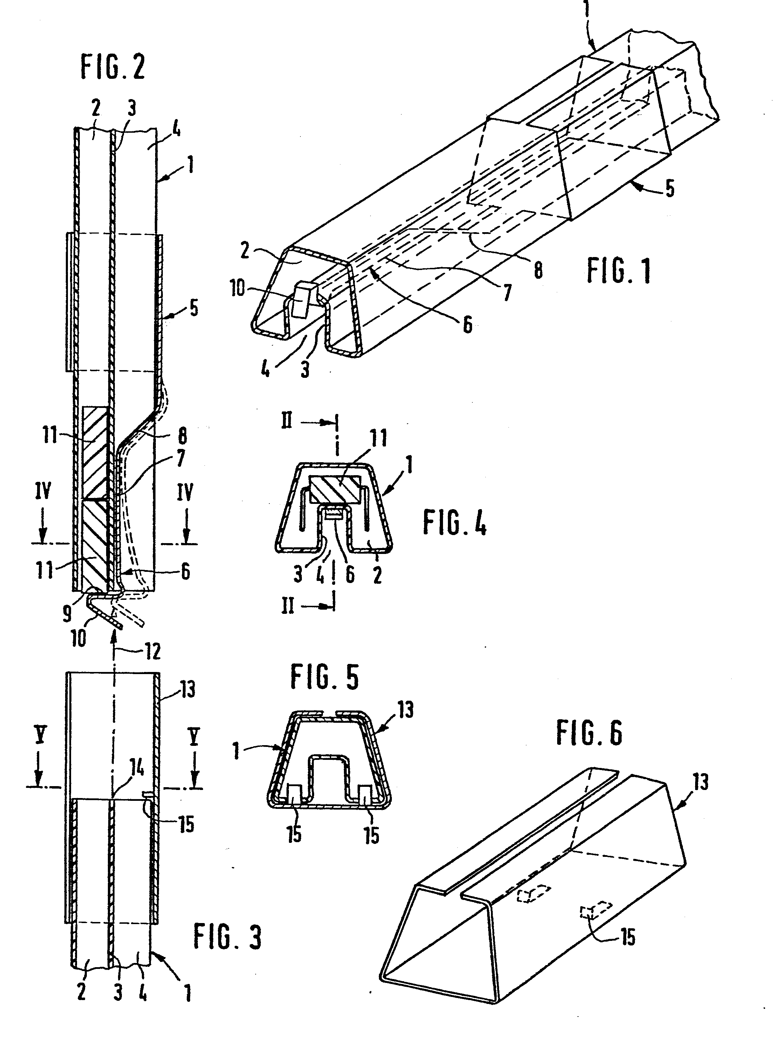

         Fig. 1 sowie einen Schnitt II-II durch Fig. 4;

Fig. 3   einen Längsschnitt durch einen Endabschnitt eines
         weiteren IC-Stangenmagazins mit aufgeschobener
         Verbindungsmuffe;

Fig. 4   einen Schnitt IV-IV durch Fig. 2;

Fig. 5   einen Schnitt V-V durch Fig. 3;

Fig. 6   eine perspektivische Darstellung der in den
         Fig. 3 und 5 gezeigten Verbindungsmuffe;

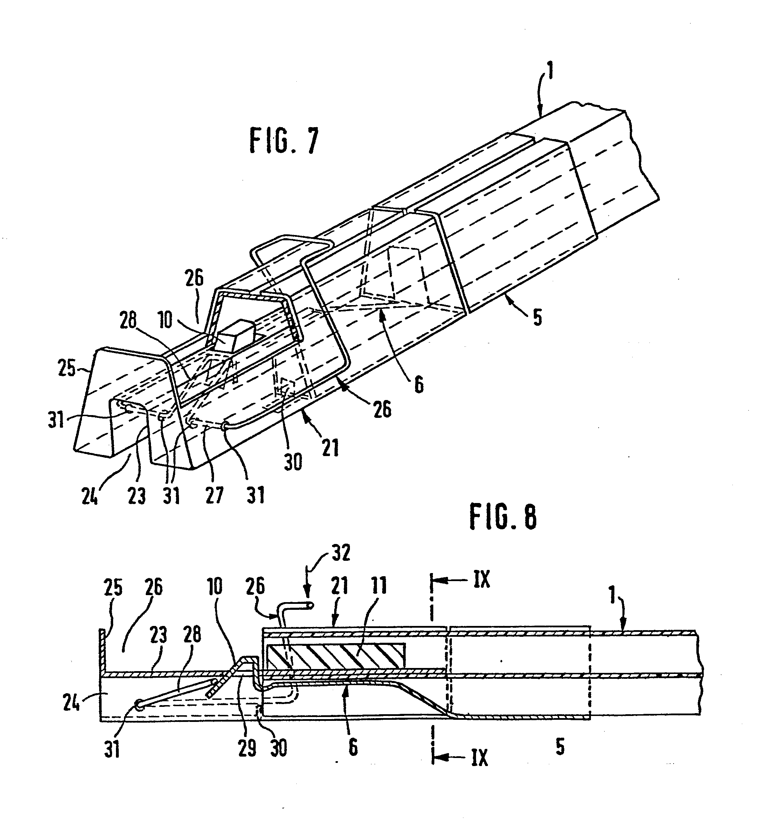

Fig. 7   eine perspektivische Darstellung eines Endabschnittes eines IC-Stangenmagazins, bestehend aus
         Hülse und federnder Zunge, wie in Fig. 1, hier
         jedoch zusätzlich mit aufgeschobenem Vereinzelungssteckteil;

Fig. 8   einen Längsschnitt durch Fig. 7;

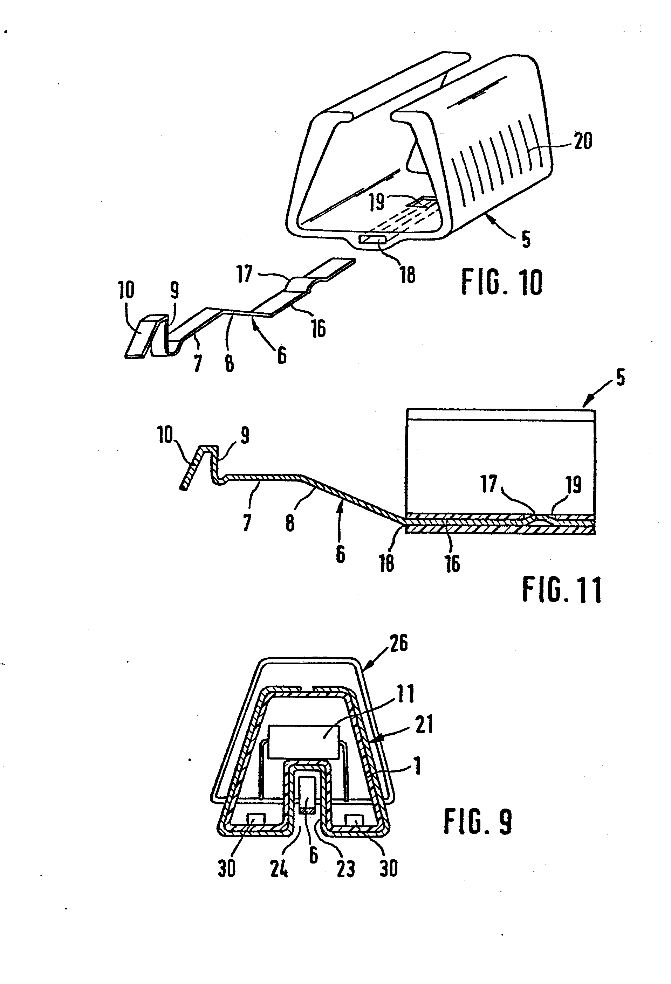

Fig. 9   einen Schnitt IX-IX durch Fig. 8;

Fig. 1o  eine andere Ausführungsform für das Abschlußstück;

Fig. 11  einen Längsschnitt durch Fig. 1o;

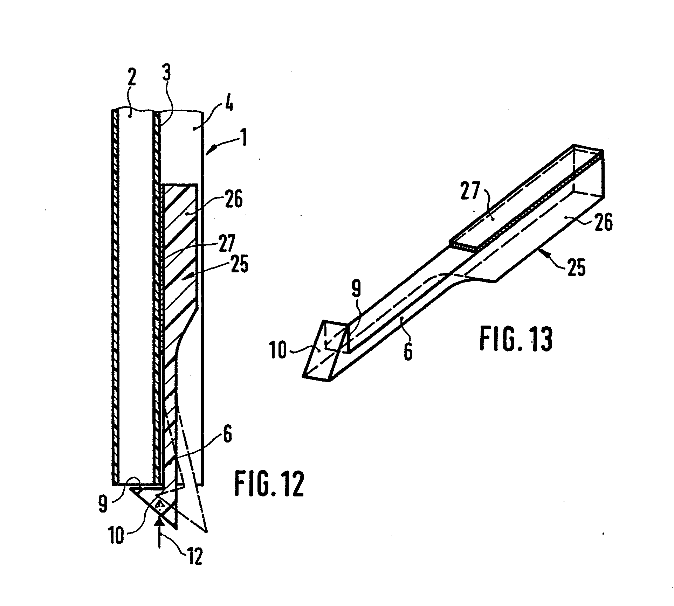

Fig. 12  einen Längsschnitt durch den Endabschnitt eines
         IC-Stangenmagazins mit einer anderen Ausführungsform des Abschlußstückes;

Fig. 13  eine perspektivische Darstellung des Abschlußstückes nach Fig. 12;

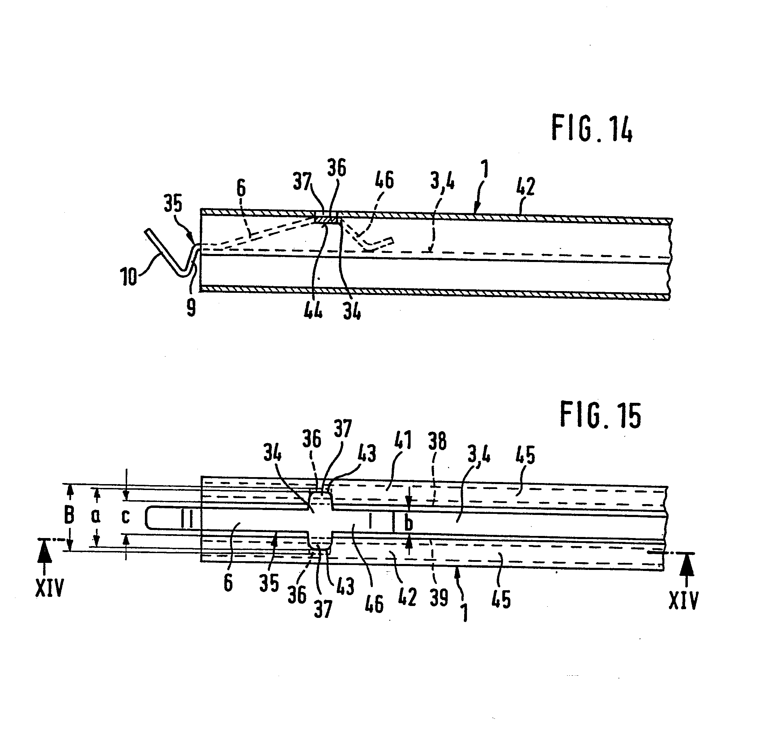

Fig. 14  eine weitere Ausführungsform eines IC-Stangenmagazins in einem Schnitt längs der Linie
         XIV-XIV in Fig. 15;

Fig. 15  eine Seitenansicht des IC-Stangenmagazins nach
         Fig. 14.

Das in Fig. 1 gezeigte IC-Stangenmagazin 1 besteht aus
durchsichtigem, antistatischem Kunststoff. Infolge einer Wandvorwölbung 3 hat die Magazinkammer 2 etwa U-Profil. Die Wandvorwölbung 3 bildet eine von außen zugängliche Rinne 4. Auf den dargestellten Endabschnitt des IC-Stangenmagazins 1 ist eine Metall-Hülse 5 aufgeschoben, die die Rinne 4 überbrückt. Die Hülse ist in Längsrichtung geschlitzt, so daß sie das IC-Stangenmagazin federnd umgreift. An der die Rinne 4 überbrückenden Seite der Hülse 5 befindet sich eine Federzunge 6. Diese weist einen in Bezug auf die Längsrichtung des Stangenmagazins schräg verlaufenden Abschnitt 8 und einen im nicht-ausgelenkten Zustand parallel zur Längsrichtung des Stangenmagazins gerade verlaufenden Abschnitt 7 auf. Der gerade Abschnitt 7 weist am Ende des Stangenmagazins 1 eine Abbiegung 9 auf, welche den im Stangenmagazin befindlichen IC's 11 den Austritt im nicht-ausgelenkten Zustand der Federzunge 6 versperrt. An der Abbiegung 9 befindet sich ferner ein schräger Bereich 1o.

Die Federzunge 6 kann von Hand oder durch einen entsprechenden Gegenanschlag ausgelenkt werden. Die ausgelenkte Stellung ist durch gestrichelte Linien angedeutet. In der ausgelenkten Stellung können die IC's aus der Magazinkammer 2 herausrutschen.

In Fig. 3 ist der Endabschnitt eines weiteren Stangenmagazins 1 gezeigt, auf den eine Verbindungsmuffe 13 aufgeschoben ist. Wenn die beiden in den Fig. 2 und 3 gezeigten Stangenmagazine 1 zusammengeschoben werden, derart, daß der obere Teil der Verbindungsmuffe 13 den freien Teil des Endabschnittes des oberen Stangenmagazins 1 umgreift, so wirkt die höchste Stelle der Wandvorwölbung 3 des unteren Stangenmagazins 1 als Anschlag (siehe Pfeil 12), der den schrägen Bereich 1o der Federzunge 6 nach rechts in die gestrichelte Öffnungsstellung verschiebt. Dadurch können die IC's 11 von dem oberen Stangenmagazin 1 in das untere Stangenmagazin 3 rutschen.

Die Verbindungsmuffe ist noch genauer in den Fig. 5 und 6 dargestellt. Man erkennt, daß auch die Verbindungsmuffe oben in Längsrichtung des Stangenmagazins geschlitzt ist und dadurch die zu verbindenden Stangenmagazine 1 federnd umgreifen kann. Am Boden der Verbindungsmuffe 13, die vorzugsweise aus Metallblech hergestellt wird, sind Anschläge 15 für die Stangenmagazine 1 ausgebogen.

Fig. 4 zeigt im Schnitt wie die IC's 11 in dem Stangenmagazin 1 angeordnet sind. Die IC-Körper ruhen dabei auf der höchsten Stelle der Wandvorwölbung 3. Die Anschlußbeine der IC's ragen in die die U-Schenkel der Magazinkammer 2 bildenden Kammerbereiche.

Die Fig. 7, 8 und 9 zeigen den in Fig. 1 dargestellten Endabschnitt des Stangenmagazins 1 zusätzlich mit einem Vereinzelungssteckteil 21. Dieses hat ein Profil wie die Hülse 5 und ist ebenfalls oben geschlitzt. Es kann einstückig mit der Hülse ausgebildet sein oder -wie dargestellt- getrennt von letzterer. Das Vereinzelungssteckteil 21 weist eine Entnahmeöffnung 33 auf, deren Länge etwa gleich derjenigen der IC's 11 in dem Stangenmagazin 1 ist oder etwas größer. Am Ende weist das Vereinzelungssteckteil 21 eine Wand 25 auf, die einen Anschlag für die aus dem Stangenmagazin 1 austretenden IC's bildet.

Im Gegensatz zu der Hülse 5 ist das Vereinzelungssteckteil 21 ebenso wie das Stangenmagazin 1 mit einer Wandvorwölbung 23 versehen, die eine von außen zugängliche Rinne 24 bildet. Durch diese Rinne 24 erstreckt sich die Federzunge 5. Die Umbiegung der Federzunge sowie der schräge Bereich 1o tauchen durch eine Öffnung 29, die sich nächst am Ende des Stangenmagazins 1 an der höchsten Stelle der Wandvorwölbung 23 befindet.

Um die Federzunge 6 in die Öffnungsstellung zu bringen,

ist hier ein Drahtbügel 26 vorgesehen. Dieser erstreckt sich durch die Löcher 31 in den Wandteilen des Vereinzelungssteckteiles 26 und weist eine Ausbiegung 28 auf, welche sich zwischen dem schrägen Bereich 1o der Federzunge 6 und der höchsten Stelle der Wandvorwölbung 23 erstreckt. Wenn man auf den Drahtbügel gemäß Pfeil 32 von oben einen Druck ausübt, so wird der Drahtbügel um den Drehpunkt in den Durchstecklöchern 31 geschwenkt. Dabei wird die Ausbiegung 28 mitgeschwenkt und lenkt die Federzunge 6 nach unten aus. Das letzte IC 11 kann dann auf den freien Rücken der Wandvorwölbung 23 rutschen und von dort entnommen werden. Beim Loslassen des Drahtbügels 26 hebt die Federzunge 6 das ausgetretene IC etwas an, wodurch die Entnahme erleichtert wird. Das Vereinzelungssteckteil weist an seinem Boden noch Anschlagausbiegungen 3o für das Stangenmagazin 1 auf, die ähnlich den Anschlagausbiegungen 15 in Fig. 6 an der Verbindungsmuffe 13 sind.

In den Fig. 1o und 11 ist noch eine alternative Ausführungsform für die Hülse mit Federzunge gezeigt. Die Hülse 5 besteht hier aus einem Kunststoff-Spritzteil, das mit einem Einsteckkanal 18 für die aus Metall bestehende Federzunge 6 versehen ist. Letztere weist einen geraden Abschnitt 16 auf, der eine wellenartige Ausbiegung 17 hat. Dieser rastet in eine gegen den Innenraum der Hülse 5 hin gerichtete Öffnung 19 des Einsteckkanals 18 ein. Zu erwähnen ist noch, daß auch die in Fig. 6 gezeigte Verbindungsmuffe 13 einstückig mit der Hülse 5 ausgebildet sein kann. Selbstverständlich müssen dann die Materialien entsprechend gewählt werden.

Fig. 12 zeigt eine andere Ausführungsform des Abschlußstückes, das hier mit 25 bezeichnet ist. Dieses Abschlußstück ist in Fig. 13 noch einmal perspektivisch dargestellt. Das aus Kunststoff bestehende Abschlußstück 25 hat einen dickeren Trägerkörper 26 und ein dünneres Zungenelement 6, das an den Trägerkörper 26 einstückig angeformt ist. Das Zungenelement 6 ist an seinem Ende mit einer Abkantung 9 versehen, welche die Meßkammer-Öffnung in unausgelenktem Zustand verschließt. Der ausgelenkte Zustand ist in gestrichelten Linien dargestellt. Man erkennt, daß die Meßkammer-Öffnung hier freigegeben ist. Die Abbiegung 9 ist mit einem sich in Bezug auf die Längsrichtung des Stangenmagazins 1 schräg erstreckenden Bereich 1o versehen. Stößt dieser schräge Bereich 1o gegen einen durch den Pfeil 12 angedeuteten Anschlag, so wird das Zungenelement 6 ausgelenkt und gibt die Meßkammer-Öffnung frei.

Der dickere Trägerkörper 26 ist an derjenigen Seite, der sich die Abkantung 9 hin erstreckt, mit einer Klebschicht 27 versehen. Mittels dieser Klebschicht 27 ist das Abschlußstück 25 auf dem Boden der Rinne 4 aufgeklebt, die durch die U-förmige Wandvorwölbung des IC-Stangenmagazins 1 gebildet ist.

Das Abschlußstück 25 in den Fig. 12 und 13 hat gegenüber dem Abschlußstück 5 in den Fig. 1 und 2 den Vorzug, daß es den Umfang des IC-Stangenmagazins 1 nicht vergrößert. Dies ist insbesondere dann wichtig, wenn das IC-Stangenmagazin beispielsweise in einen Adapter eingesteckt wird, der ein an den Umfang des IC-Stangenmagazins angepaßtes Einführloch besitzt.

Bei der Ausführungsform gemäß Fig. 14 und 15 ist das hier mit 35 bezeichnete Abschlußelement ebenfalls im von der U-förmigen Wandvorwölbung 3 gebildeten Kanal 4 eingesetzt und darin befestigt. Das Abschlußelement 35 weist an einem Schaftteil 34 seitliche, einander gegenüberliegende Ansätze 36 auf, die trapezförmig zugespitzt sind und in Aussparungen 37 stecken, die in den einander gegenüberliegenden Seitenwänden 38,39 der Wandvorwölbung 3 eingearbeitet sind. Dabei setzen die Aussparungen 37 sich in den Wänden 41,42 fort, die sich an die Wandvorwölbung 3 in Umfangsrichtung anschließen. Aufgrund dieser Ausgestaltung sind die Aussparungen 37 sowohl zur Wandvorwölbung 3 hin als auch zu der betreffenden Außenseite des Stangenmagazins 1 hin offen. Diese Ausgestaltung ermöglicht es in einfacher Weise , die Aussparungen 37 durch einen Fräser, beispielsweise einen Fingerfräser, einzuarbeiten, dessen Längsachse radial zur Längsachse des Stangenmagazins 1 gerichtet ist. Wenn die Aussparungen 37 in vorbeschriebener Weise mit einem sich drehenden spanabhebenden Werkzeug eingearbeitet werden, sind ihre einander abgewandten Ränder 43 gerundet. Die seitlichen Ansätze 36 untergreifen diese Ränder gringfügig, wie es in Fig. 15 deutlich zu erkennen ist. Deshalb sind die seitlichen Ansätze 36 zwischen den Wänden 41,42 und den mit 44 bezeichneten, inneren Längskanten der Aussparungen 37 gehalten. Zwecks Verdrehsicherung in der Befestigungsposition empfiehlt es sich, die Querschnittsform der Aussparungen 37 der Querschnittsform der Ansätze 36 anzupassen, so daß die Ansätze 36 verdrehsicher in den Aussaprungen 37 aufgenommen sind.

Zur Montage bzw. Demontage des Abschlußstücks 35 ist es lediglich notwendig, die mit 45 bezeichneten Stege des U-förmigen Profils des Stangenmagazins 1 auseinanderzudrücken, und zwar so weit, daß die Ansätze 36 die Ränder 43 nicht mehr untergreifen. Sobald die Ansätze 36 freiliegen, kann das Abschlußstück 35 entnommen werden. Bei der Montage des Abschlußstücks 35 ist entsprechend umgekehrt zu verfahren.

Zum Zweck seiner Stabilisierung weist das Abschlußstück 35 an seinem der Federzunge 6 abgewandten Ende einen Stützschenkel 46 auf, der sich bis zum Grund der Wandvorwölbung 3 erstreckt. Da die Federzunge 6 ebenfalls schräg zum Grund der Wandvorwölbung 3 verläuft und vor der Abbiegung 9 am Grund der Wandvorwölbung 3 anliegt, ist das Abschlußstück 35 verdrehsicher in den Aussparungen 37 aufgenommen. Die vorgenannten Maßnahmen sind eine zusätzliche Maßnahme zum formschlüssigen Eingriff der Ansätze 36 in die Aussparungen 37, die an sich schon eine Verdrehsicherung darstellt.

Die seitliche Führung des Abschlußstücks 35 ist dadurch gegeben, daß die am Grund der Wandvorwölbung 23 liegenden Teile des Abschlußstücks 35 etwa gleich breit (b) bemessen sind, wie der Grund der Wandvorwölbung 3, was in der Fig. 15 durch sich längs erstreckende Lichtkanten erkennbar ist. Die über die Spitzen der Ansätze 36 gemessene Breite ist in Fig. 15 mit B bezeichnet. Diese Breite B ist um ein deutliches Maß größer als die Breite c im äußeren Bereich des Kanals 4 und auch geringfügig größer als der Abstand a, den die Ränder 43 voneinander aufweisen.

Das Abschlußstück 35 ist einstückig aus Blattfederstahl ausgestanzt. Nach dem Stanzen sind der Stützschenkel 46, der Schrägverlauf der Federzunge 6, die Abbiegung 9 und der schräge Bereich 1o an der Spitze der Federzunge 6 durch Biegen angeformt worden.

ANSPRÜCHE

1. IC-Stangenmagazin, insbesondere solches, dessen
   Magazinkammer-Profil infolge einer nach innen gerichteten Wandvorwölbung etwa U-Form hat,
   dadurch gekennzeichnet,
   daß es ein am Ende des IC-Stangenmagazins angeordnetes
   auslenkbares Federelement (6) aufweist, welches die
   Magazinkammer-Öffnung im unausgelenkten Zustand zumindest soweit verschließt, daß die in der Magazinkammer befindlichen IC's (11) am Austritt gehindert
   werden, und welches den Austritt der IC's (11) im
   entgegen der Federkraft ausgelenkten Zustand zuläßt.

2. IC-Stangenmagazin nach Anspruch 1,
   dadurch gekennzeichnet,
   daß das Federelement (6) vorzugsweise einstückig
   an ihm angeformt ist.

3. IC-Stangenmagazin nach Anspruch 1 oder 2,
   dadurch gekennzeichnet,
   daß das Federelement (6) einen in Bezug auf die
   Längsrichtung des Stangenmagazins (1) schrägen Bereich (1o) aufweist, der das Auslenken des Federelementes (6) bewirkt, wenn er in Längsrichtung des
   Stangenmagazins (1) gegen einen Auslenkanschlag (z.B.
   14) gedrückt wird oder wenn der Auslenkanschlag gegen
   den schrägen Bereich (1o) gedrückt wird.

4. IC-Stangenmagazin nach Anspruch 3,
   dadurch gekennzeichnet,
   daß der schräge Bereich (1o) die gedachte in Längsrichtung des Stangenmagazins (1) verlaufende Verlängerung der höchsten Stelle der Wandvorwölbung (3)
   schneidet.

5. IC-Stangenmagazin nach einem der Ansprüche 1 bis 4,
dadurch gekennzeichnet,
daß das Federelement (6) ein separates Abschlußstück
mit einem form- oder krafschlüssig am Stangenmagazin
(1) festlegbaren Schaftteil (34) ist.

6. IC-Stangenmagazin nach einem der Ansprüche 1 bis 5,
dadurch gekennzeichnet,
daß das Federelement (6) eine sich in Längsrichtung des
Stangenmagazins (1) durch die von der Wandvorwölbung
(3) gebildete Rinne (4) gegen das Ende des Stangenmagazins (1) hin erstreckende Federzunge ist und dort
eine gegen die Magazinkammer-Öffnung hin gerichtete
Abbiegung (9) aufweist.

7. IC-Stangenmagazin nach einem der Ansprüche 3 bis 6,
dadurch gekennzeichnet,
daß sich der schräge Bereich (1o) am Ende der Abbiegung (9) des Federelementes (6) befindet.

8. IC-Stangenmagazin nach Anspruch 5,
dadurch gekennzeichnet,
daß das Schaftteil eine auf einen Endabschnitt des
Stangenmagazins (1) aufschiebbare und diesen zumindest
teilweise umgreifende Hülse (5) ist.

9. IC-Stangenmagazin nach Anspruch 8,
dadurch gekennzeichnet,
daß die Hülse (5) die von der Wandvorwölbung (3)
gebildete Rinne (4) überbrückt, und daß die Federzunge (6), von der Hülse (5) ausgehend, in Bezug auf
die Längsrichtung des Stangenmagazins (1) durch die
Rinne (4) zumindest teilweise schräg zum Ende des
Stangenmagazins (1) hin verläuft und dort im unausgelenkten Zustand am Boden der Rinne (4) anliegt.

10. IC-Stangenmagazin nach einem der vorhergehenden Ansprüche,
dadurch gekennzeichnet,
daß die Hülse (5) und/oder das Federelement (6) insbesondere einstückig ausgebildet und vorzugsweise aus Metall hergestellt sind.

11. IC-Stangenmagazin nach einem der Ansprüche 1 bis 1o,
dadurch gekennzeichnet,
daß die Hülse (5) aus Kunststoff gespritzt ist, und daß das Federelement (6) aus Metall besteht und an der Hülse (5) befestigt ist.

12. IC-Stangenmagazin nach einem der Ansprüche 8 bis 11,
dadurch gekennzeichnet,
daß die aus Kunststoff gespritzte Hülse (5) einen sich in Längsrichtung des Stangenmagazins (1) erstreckenden Einsteckkanal (18) für die Federzunge (6) aufweist.

13. IC-Stangenmagazin nach Anspruch 12,
dadurch gekennzeichnet,
daß der Einsteckkanal (18) mit einer gegen den Innenraum der Hülse (5) hin offenen Ausnehmung (19) versehen ist, und daß der in den Einsteckkanal (18) einführbare Teil (16) der Federzunge (6) mit einer wellenartigen Ausbiegung (17) versehen ist, die beim Einschieben der Federzunge (6) in den Einsteckkanal (18) in die Ausnehmung (19) einrastet.

14. IC-Stangenmagazin nach einem der Ansprüche 1 bis 7,
dadurch gekennzeichnet,
daß das Federelement (25) in den von der U-förmigen Wandvorwölbung (3) gebildeten Kanal (4) eingesetzt und darin befestigt ist.

15. IC-Stangenmagazin nach Anspruch 14,
    dadurch gekennzeichnet,
    daß das Federelement (25) in die U-förmige Wandvorwölbung (3) eingeklebt ist.

16. IC-Stangenmagazin nach einem der Ansprüche 1 bis 7,
    dadurch gekennzeichnet,
    daß das Federelement (25) aus einem Kunststoffstück
    besteht, das von einem dickeren Trägerkörper (26)
    und einem einstückig mit diesem verbundenen dünneren
    Zungenelement (6) besteht, und daß am Ende des Zungenelementes (6) eine gegen die Meßkammer-Öffnung hin
    gerichtete Abkantung (9) vorgesehen ist.

17. IC-Stangenmagazin nach Anspruch 16,
    dadurch gekennzeichnet,
    daß der Trägerkörper (26) mit einer Klebeschicht
    (27) versehen ist.

18. IC-Stangenmagazin nach einem der Ansprüche 1 bis 7,
    dadurch gekennzeichnet,
    daß in den einander gegenüberliegenden Seitenwänden
    (38,39) der Wandvorwölbung (3) bevorzugt einander
    gegenüberliegende Aussparungen (37) vorgesehen sind,
    in die zwei seitliche Ansätze am Schaftteil (34)
    des Federelementes (35) einfassen.

19. IC-Stangenmagazin nach einem der Ansprüche 19 bis 21,
    dadurch gekennzeichnet,
    daß die Aussparungen (37) sich in die Wände (41,42)
    fortsetzen, die an die Wandvorwölbung (3) in Umfangsrichtung anschließen und die einander abgewandten
    Ränder (43) der Aussparungen bevorzugt gerundet sind.

2o. IC-Stangenmagazin nach einem der vorhergehenden
    Ansprüche,
    dadurch gekennzeichnet, daß dazu zusätzlich ein IC-Vereinzelungssteckteil (21) gehört, das -vom Ende des Stangenmagazins (1) aus gesehen- vor dem Schaftteil (34) bzw. die Hülse (5) auf den Endabschnitt des Stangenmagazins (1) aufschiebbar ist und über das Ende des Stangenmagazins (1) hinausragt, daß das Vereinzelungssteckteil (21) eine in Bezug auf die Längsrichtung des Stangenmagazins (1) seitliche Entnahmeöffnung (2o) aufweist, deren in Längsrichtung des Stangenmagazins (1) gemessene Länge gleich oder etwas größer ist als die Länge der im Stangenmagazin (1) befindlichen IC's, daß das Vereinzelungssteckteil (21) am Ende der Entnahmeöffnung (2o) einen Anschlag (25) für die IC's (11) aufweist, und daß an dem Vereinzelungssteckteil (21) ein von Hand betätigbares Auslenkelement (26,27,28) für das Federelement (6) vorgesehen ist.

21. IC-Stangenmagazin nach Anspruch 2o,
dadurch gekennzeichnet,
daß das Vereinzelungssteckteil (21) etwa die gleiche Querschnittsform wie und lediglich geringfügig größere Abmessungen als das Stangenmagazin (1) hat, derart, daß es dessen Endabschnitt mit Preßsitz umgreifen kann, daß der über das Ende des Stangenmagazins (1) überstehende Abschnitt des Vereinzelungssteckteils (21) eine die Entnahmeöffnung (2o) bildende Wandaussparung aufweist, die sich etwa oberhalb der höchsten Stelle der nach innen gerichteten Wandvorwölbung (23) befindet, daß sich am Ende des Vereinzelungssteckteils (21) eine den Anschlag für die IC's bildende Abschlußwand (25) befindet, und daß in der Wandvorwölbung (23) des Vereinzelungssteckteils (21) ein Durchgreifloch (29) für das Federelement (6) vorgesehen ist.

22. IC- Stangenmagazin nach Anspruch 3 und 2o oder 21,
dadurch gekennzeichnet, daß das Auslenkelement von einem Drahtbügel (26) gebildet ist, der sich drehbar quer durch das Vereinzelungssteckteil (21) erstreckt und in der von der
Wandvorwölbung (23) gebildeten Rinne (24) eine Ausbiegung (28) aufweist,welche sich zwischen dem schrägen
Bereich (1o) des Federelementes (6) und dem Boden
der Rinne (24) erstreckt.

23. IC-Stangenmagazin nach einem der Ansprüche 2o bis 22,
dadurch gekennzeichnet,
daß das Vereinzelungssteckteil (21) aus Blech oder
Kuststoff hergestellt ist.

24. IC-Stangenmagazin nach einem der Ansprüche 21 bis 23,
dadurch gekennzeichnet,
daß die das Federelement (6) tragende Hülse (5) und
das Vereinzelungssteckteil (21) einstückig ausgebildet
sind.

25. IC-Stangenmagazin nach einem der Ansprüche 3 bis 24,
dadurch gekennzeichnet,
daß dazu zusätzlich eine Verbindungsmuffe (13) zum
Verbinden des Endabschnittes des Stangenmagazins (1)
mit einem Endabschnitt eines zweiten Stangenmagazins
(1) oder zum Aufstecken des Stangenmagazins (1) auf
ein Übernahme-Anschlußstück gehört, das den gleichen
Querschnitt wie das Stangenmagazin (1) hat, wobei die
höchste Stelle der Wandvorwölbung (3) am Ende des
zweiten Stangenmagazins (1) bzw. am Ende des Übernahme-Endstückes den Auslenkanschlag für das Federelement (6) bildet.

26. IC-Stangenmagazin nach Anspruch 25,
dadurch gekennzeichnet,
daß die Verbindungsmuffe (13) aus Kunststoff oder
Blech hergestellt ist.

27. IC-Stangenmagazin nach Anspruch 25 oder 26, dadurch gekennzeichnet, daß die Verbindungsmuffe (13) und die das Federelement (6) tragende Hülse (5) einstückig ausgebildet oder getrennte Teile sind.

FIG.2

FIG.1

FIG.4

FIG.5

FIG.3

FIG.6

**FIG. 7**

**FIG. 8**

FIG. 10

FIG. 11

FIG. 9

FIG.12

FIG.13

FIG.14

FIG.15